# EUROPÄISCHE PATENTSCHRIFT

(11) **EP 0 648 343 B1**
(45) Veröffentlichungstag und Bekanntmachung des Hinweises auf die Patenterteilung: **31.07.1996**
(21) Anmeldenummer: 94915543.6
(22) Anmeldetag: 26.04.1994
(51) Int. Cl.: G02B 3/08, G03F 7/20

(54) **LITHOGRAFISCH HERGESTELLTE STUFENLINSE FRESNELSCHER OBERFLÄCHENSTRUKTUR UND VERFAHREN ZU IHRER HERSTELLUNG**
LITHOGRAPHICALLY PRODUCED STEPPED LENS WITH A FRESNEL SURFACE STRUCTURE AND PROCESS FOR PRODUCING IT
LENTILLE A ECHELONS REALISEE DE MANIERE LITHOGRAPHIQUE, AYANT UNE STRUCTURE SUPERFICIELLE DE TYPE FRESNEL, ET SON PROCEDE DE REALISATION

(30) Priorität: 29.04.1993 DE 4314574
(43) Veröffentlichungstag der Anmeldung: 19.04.1995
(73) Patentinhaber: JENOPTIK Technologie GmbH, D-07745 Jena (DE)
(72) Erfinder: KLEY, Ernst-Bernhard, D-07749 Jena (DE)
(74) Vertreter: Geyer, Werner
(86) Internationale Anmeldenummer: EP9401307
(87) Internationale Veröffentlichungsnummer: WO9425881

(56) Entgegenhaltungen:
- US-A- 3 893 856
- APPLIED OPTICS, Bd. 26, Nr. 3, 1. Februar 1987, New York, US, Seiten 587-591; T. SHIONO et al.: "Rectangular-apertured micro-Fresnel lens arrays fabricated by electron-beam lithography"

## Beschreibung

Die Erfindung betrifft eine lithografisch hergestellte Stufenlinse fresnelscher Oberflächenstruktur mit radialsymmetrisch oder elliptisch optischer Wirkung durch Überlagerung von Strahlungsdosisverteilungen von Zylinderlinsen mit zueinander um einen Winkel versetzten Zylinderachsen.
Gegenstand der Erfindung ist außerdem ein Verfahren zur Herstellung von Stufenlinsen, bei dem eine Strukturierung einer Resistschicht durch Übereinanderbelichten zweier Strahlungsdosisverteilungen von Zylinderlinsen mit um einen Winkel versetzten Zylinderachsen und durch einen anschließenden Entwicklungsvorgang, bei dem ein Voranschreiten einer Entwicklungsfront in der Tiefe der Schicht gestoppt wird, erfolgt.

Linsenstrukturen müssen lateral und im Profil eine hohe Genauigkeit besitzen. Lithografische Verfahren zur Herstellung von Linsen mit eingeschränkten Abmessungen sind seit langem bekannt. Die mit Licht, Elektronen-, Röntgen- oder mit Ionenstrahlen arbeitenden lithografischen Verfahren sind prinzipiell zur Herstellung solcher Profile geeignet. In vielen Fällen tritt bei schreibenden Verfahren jedoch das Problem langer Bearbeitungszeiten auf. Ursache dafür ist die notwendige Zerlegung der gekrümmten Strukturgeometrien in eine hohe Anzahl elementarer Strukturdetails, die zur Repräsentation der Profiloberfläche abzuarbeiten sind.

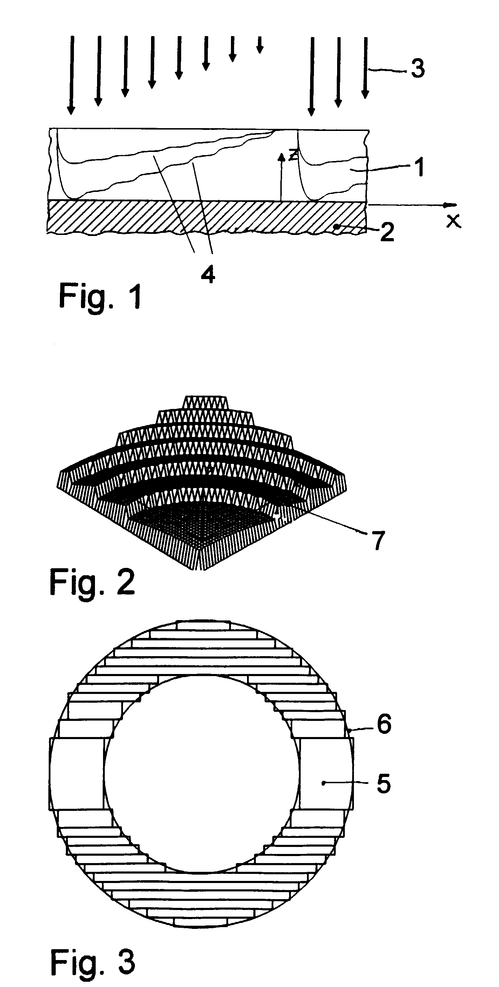

Dieser Umstand läßt sich an Hand der elektronenlithografischen Herstellung eines refraktiven Mikrolinsenarrays verdeutlichen. Das diesem Beispiel zugrunde liegende Verfähren ist unter der Bezeichnung "variable dose writing" bekannt und nutzt die Tatsache, daß die Lösungsgeschwindigkeit eines elektronenempfindlichen Resists im Entwicklerbad mittels der in den Resist eingebrachten Elektronendosis vorbestimmt werden kann. Dadurch ist es möglich, die laterale Elektronendosisverteilung so zu gestalten, daß man mit dem Abbruch der Entwicklung nach einer bestimmten Zeit das gewünschte Oberflächenprofil erhält. Figur 1 verdeutlicht diese Verfahrensweise schematisch.

Im Fall radialsymmetrischer Linsenkrümmung der Einzellinse und einer endlichen Höhenstufung im Profil ergeben sich ringförmige abzuarbeitenden Bereiche gleicher Elektronendosis. Wird die Linse zur effizienten Anordnung im Array quadratisch begrenzt, sind die äußeren Ringe gleicher Elektronendosis nicht geschlossen. Der anfallende DatenaufWand ist groß und bewirkt eine relativ langsame Abarbeitung jeder einzelnen Linse.
Sehr schnelle Elektronenstrahlbelichtungsanlagen arbeiten mit einem variablen Formstrahl rechteckigen Querschnittes. Ihre potentielle Belichtungsgeschwindigkeit ist aber nur dann nutzbar, wenn die parallel zu den Koordinatenachsen rechteckige Elektronensonde möglichst großflächig nutzbar ist. Gerade das ist im vorliegenden Beispiel nicht möglich, denn es müssen zur Approximation des Kreisringes sehr viele kleine Rechtecke abgearbeitet werden. Figur 2 zeigt schematisch die Zerlegung eines Kreisringes in Rechtecke. Auch bei Verwendung einer schnellen Elektronenstrahlbelichtungsanlage resultieren daraus unbefriedigend lange Bearbeitungszeiten.

Nach der Offenlegungsschrift DE 17 72 567 ist es bekannt, unterschiedliche optische Weglängen durch geeignete, periodisch unterschiedliche Belichtung und nachfolgende Entwicklung und Rehalogenierung und/oder gerbende Entwicklung einer fotografischen Schicht zu erzeugen.
Raster von sphärischen Linsen entstehen, wenn in quadratischer Anordnung zwei Systeme von aufeinander senkrecht stehenden Linien aufbelichtet werden. Von Nachteil ist es, daß mit dieser Lösung lediglich Linsenraster mit in sich im wesentlichen gleichgestalteten Linsen geringerer optischer Qualität herstellbar sind."

Aufgabe der Erfindung ist es, die hohe potentielle Belichtungsgeschwindigkeit schneller Elektronenstrahlbelichtungsanlagen, die mit variablem rechteckigen Strahlungsquerschnitt arbeiten, in eine hohe Effektivität zur Herstellung von Stufenlinsen fresnelscher Art umzusetzen und dabei die benötigten Datenmengen zu reduzieren.

Erfindungsgemäß wird die Aufgabe durch eine Lithografisch hergestellte Stufenlinse fresnelscher Oberflächenstruktur mit radialsymmetrisch oder elliptisch optischer Wirkung durch Überlagerung von Strahlungsdosisverteilungen von Zylinderlinsen mit zueinander um einen Winkel versetzten Zylinderachsen, dadurch gelöst, daß zur Erzeugung der Oberflächenstruktur mindestens eine Strahlungsdosisverteilung einer Fresnel-Zylinderlinse entspricht.

Bei einer speziellen lithografisch hergestellten Stufenlinse ist die Oberflächenstruktur durch die Überlagerung der Strahlungsdosisverteilungen von zwei Fresnel-Zylinderlinsen mit rechtwinklig zueinander gerichteten Zylinderachsen erzeugt und weist Stufen in Form von benachbarten Stufenelementen auf, die in ein durch ihre rechtwinklig zueinander gerichteten Flanken gebildetes, mit zunehmendem Abstand vom Zentrum der Linse enger werdendes Gitternetz eingebettet sind,
wobei die Flanken an ihren Schnittpunkten und an Punkten des Lotes vom Zentrum auf die Flanken gemeinsam mit dem Zentrum Orte gleicher Höhen bilden. Für jedes Stufenelement liegen von den Orten gleicher Höhen ausgehende Höhenreduzierungen vor, die innerhalb jeder Richtung senkrecht zu den Flanken und zum Rand der Linse weisend von Flanke zu Flanke gleichgroß sind und in Richtung der entferntesten, zum Rand der Linse gelegenen Schnittpunkte der Summe der von Flanke zu Flanke auftretenden Höhenreduzierungen eines Stufenelementes entsprechen.

Vorteilhafterweise besitzen die Höhenreduzierungen innerhalb der Richtungen senkrecht zu den Flanken ein Maß, mit dem ein Phasensprung vom ganzzahligen Vielfachen einer Wellenlänge realisiert wird.

Gegenstand der Erfindung ist außerdem ein Verfahren zur Herstellung von Stufenlinsen vom fresnelschen Typ, bei dem eine Strukturierung einer Resistschicht durch Übereinanderbelichten zweier Strahlungsdosisverteilungen von Zylinderlinsen mit um einen Winkel versetzten Zylinderachsen und durch einen anschließenden Entwicklungsvorgang, bei dem ein Voranschreiten einer Entwicklungsfront in der Tiefe der Schicht gestoppt wird, erfolgt. Mindestens eine von den übereinanderbelichteten Strahlungsdosisverteilungen entspricht einer Fresnel-Zylinderlinse.

Es ist von Vorteil, wenn die eine Strahlungsdosisverteilung einem fresnelschen Linsenprofil und die andere einem klasischen Linsenprofil entspricht.

Vorteilhaft ist es auch, wenn beide Strahlungsdosisverteilungen einem fresnelschen Linsenprofil entsprechen.

Außerdem ist es von Vorteil, wenn beide Strahlungsdosisverteilungen einem klassischen Linsenprofil entsprechen.

Es ist sowohl möglich, die erforderlichen Belichtungen zuerst nacheinander durchzuführen und anschließend zeitlich begrenzt zu entwickeln als auch Belichtung und Entwicklung abwechselnd auszuführen.

Durch die Erfindung ist es möglich, auf sehr effiziente Weise 3-dimensional gekrümmte Oberflächen in Form von Belichtungsdaten für lithografische Patterngeneratoren zur Verfügung zu stellen.
Die Daten für die jeweilige Einzelstruktur besitzen einen vergleichsweise geringen Umfang und sind auf geeigneten Anlagen (z.B. Belichtungsanlagen mit variablem Formstrhal) erheblich schneller abarbeitbar, als die durch Zerlegung der Ringstruktur entstehenden umfangreichen Datenmengen.
Durch die Erfindung, insbesondere durch Kombination, Variation der Zahl und der Anordnung der Zylinderlinsenprofile ist es außerdem möglich, mit einem gegrenzten Vorrat an relativ einfach strukturierten Datensätzen für spezielle Dosisverteilungen eine Vielzahl von Fresnellinwn mit bestimmten Eigenschaften herzustellen. Im Gegensatz war es bisher bei einer ringförmigen lithografischen Herstellung von Fresnellinsen bei jeder Änderung erforderlich war, den Datensatz vollständig zu überarbeiten.

Die gemäß der Erfindung hergestellten Fresnellinsen, die in ihrer Wirkung einer Fresnel-Linse mit herkömmlicher Ringstruktur entsprechen, besitzen zusätzlich verbesserte Eigenschaften bezüglich der chromatischen Abberation aufgrund ihrer Oberflächenstrukturierung, insbesondere der speziellen Stufenhöhenabfälle.

So ist es möglich, mehrere Dosisprofile unterschiedlicher optischer Funktionen übereinander zu belichten.
Die nicht orthogonale Anordnung der Zylinderachsen liefert parallelogrammförmige Randbegrenzungen bzw. Flankenanordnungen der Linsenprofile.
Ein runder Linsenrand entsteht bei refraktiven Linsenprofilen, wenn die Dicke der Resistschicht so bestimmt ist, daß bei einer bestimmten Höhenlinie auf das Substrat durchentwickelt wird.
Durch Mehrfachanordnung der einzelnen Strukturen nebeneinander werden Linsenarrays erzeugt.
Das Erfindung ist sinngemäß auf eine binäre Strukturierung mit Maskentechnik und Ätzschritten übertragbar.

Die erfindungsgemäß hergestellten Linsenprofile werden galvanisch abgeformt und zur Herstellung von Linsen auf bekannte Weise repliziert.

Die Erfindung soll nachstehend anhand der schematischen Zeichnung näher erläutert werden. Es zeigen:
- Fig. 1:: die Erzeugung eines Oberflächenprofils mittels Elektronenstrahlbelichtung und anschließender Entwicklung
- Fig. 2:: einen Ausschnitt aus einer herkömmliche Fresnel-Linse
- Fig. 3:: die Erzeugung eines Kreisringes durch eine Rechteckzerlegung
- Fig. 4a:: eine Dosisverteilung für ein erstes, in x-Richtung eines karthesischen Koordinatensystems ausgebildetes Zylinder-Linsen-Profil
- Fig. 4b:: ein Profil einer Zylinderlinse, erzeugt mit einer Dosisverteilung gemäß Fig. 4a
- Fig. 5a:: eine Dosisverteilung für ein zweites, in y-Richtung des karthesischen Koordinatensystems ausgebildetes Zylinder-Linsen-Profil
- Fig. 5b: ein Profil einer Zylinderlinse, erzeugt mit einer Dosisverteilung gemäß Fig. 5a
- Fig. 6a:: Dosisverteilungen für eine radiale Linse von klassischen Typ mit quadratischer Grundfläche
- Fig. 6b:: ein Profils einer radialen Linse vom klassischen Typ, erzeugt durch Überlagerung der Dosisverteilungen gemäß Fig. 6a
- Fig. 7a, b:: Profile von Zylinderlinsenarrays mit rechtwinklig zueinander gerichteten Zylinderachsen
- Fig. 7c:: ein Profil eines Linsenarrays durch Überlagerung von Dosisverteilungen entsprechend der Profile gemäß Fig. 7a, b
- Fig. 7d: eine Dosisverteilung
- Fig. 8a, b:: Teile von Zylinderlinsenprofilen fresnelscher Oberflächenstruktur
- Fig. 8c:: eine Ausschnitt aus einer erfindungsgemäßen Fresnellinse, die durch Überlagerung von Dosisverteilungen der Zylinderlinsenprofile gemäß Fig. 8a, b erzeugt sind
- Fig. 9a:: eine Draufsicht auf eine erfindungsgemäße quadratisch begrenzte Fresnellinse
- Fig. 9b:: eine Draufsicht auf den Ausschnitt gemäß Fig. 8c
- Fig. 10:: eine Darstellung des Höhenprofils einer erfindungsgemäßen Fresnellinse
- Fig. 11a:: ein Profil einer Zylinderlinse
- Fig. 11b:: ein Profil einer Fresnel- Zylinder-Linse
- Fig. 11c:: ein Linsenprofil gemäß der Erfindung, das durch Überlagerung der Profile gemäß Fig. 11a, b entsteht

Figur 1 veranschaulicht das technologische Verfahren zur Erzeugung eines Oberflächenprofils in einer Resistschicht 1, die auf ein Substrat 2 aufgebracht ist. Durch eine Elektronenstrahlbelichtung 3 mit variabler Dosis in der x-Richtung wird die Löslichkeit der Resistschicht 1 so verändert, daß sich im Entwicklungsprozeß eine Entwicklungsfront 4 ausbildet. In Abhängigkeit von der Belichtung und der Entwicklungszeit liegt nach Abbruch der Entwicklung eine definierte Struktur in der Resistschicht 1 vor, gemäß Fig. 1 eine in x-Richtung ausgebildete Stufenstruktur.

Sollen Fresnellinsen gemäß Fig. 2 nach diesem technologischen Verfahren hergestellt werden, ist ein datenaufwendiger Belichtungsablauf erforderlich. Fig. 3 verdeutlicht eine dazu notwendige Zerlegung eines Kreisringes 6 in Rechtecke 5, deren Größe und Form vom als Formdstrahl ausgebildeten Elektronenstrahlenbündel bestimmt ist. Jede Wirkfläche 7 der Fresnellinse wird in eine Vielzahl von Höhenschritte zerlegt, von denen jeder einem Kreisring 6 entspricht. Jedem Kreisring 6 wiederum wird eine spezielle Dosis zugeordnet.

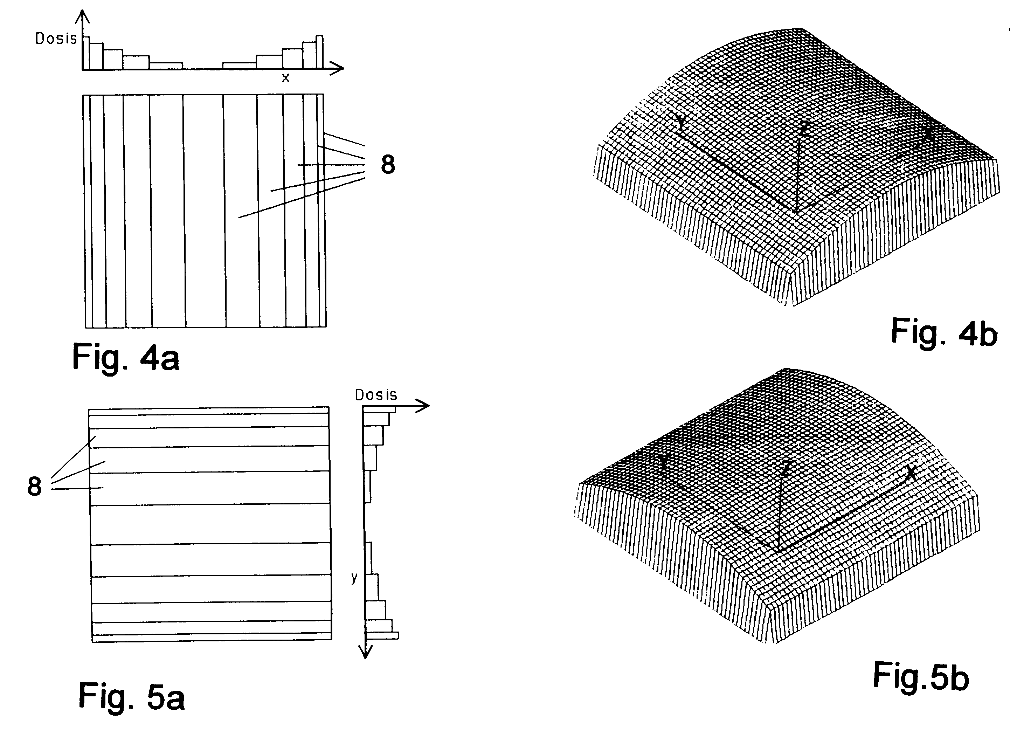

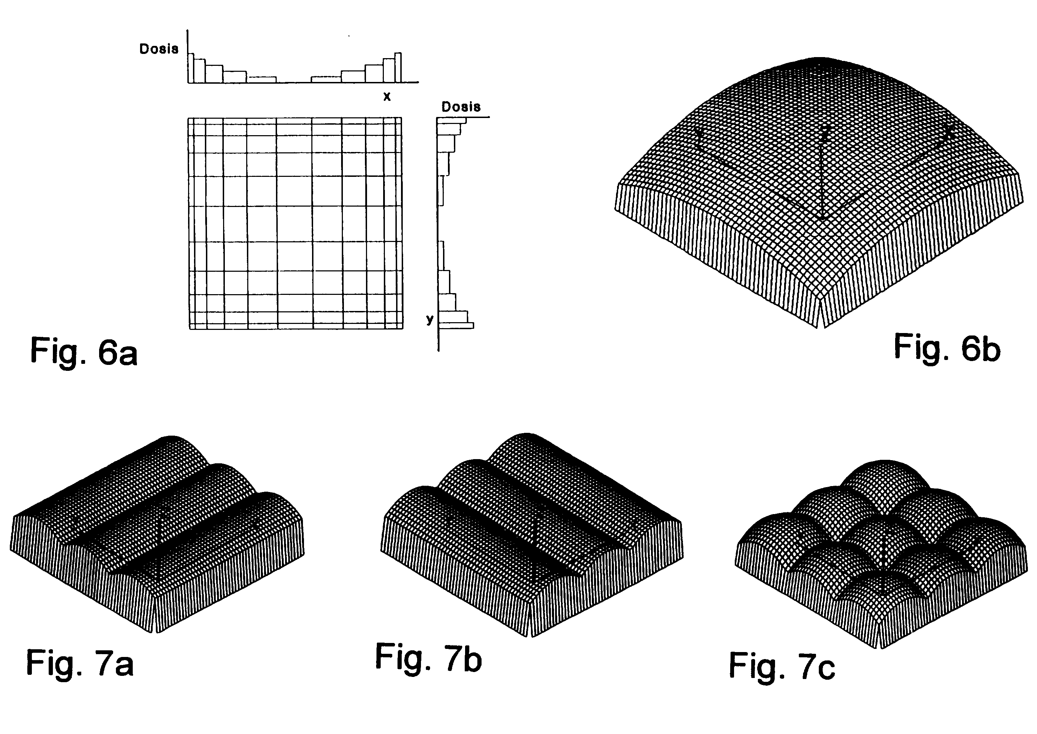

Mit den Figuren 4 bis 6 wird verdeutlicht, wie unter Verwendung bestimmter Dosisverteilungen refraktive Mikrolinsenprofile erzeugt werden können. Gekrümmte Oberflächen entsprechend den Figuren 4b und 5b entstehen bei Belichtung einer genügend großen Anzahl von Rechtecken 8 und Entwicklung. Durch Überlagerung von Dosisverteilungen von Zylinderlinsen mit rechtwinklig zueinander gerichteten Zylinderachsen und quadratischer Grundfläche gemäß Fig. 6a entsteht eine radiale Linse klassischen Typs mit quadratischer Grundfläche gemäß Fig. 6b. Ihre Brennweite ist gleich der Brennweite der Zylinderlinsen.

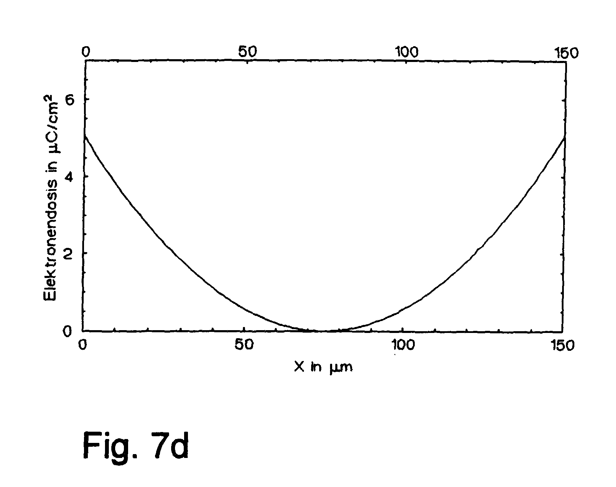

Die Figuren 7 a-d geben Beispiele an für die Erzeugung eines Linsenarrays mit quadratischer Grundfläche der Einzellinse durch Überlagerung von Dosisverteilungen zweier Zylinder-Linsenarrays gemäß Fig. 7a, b mit rechtwinklig zueinander gerichteten Zylinderachsen.

Ein refraktives Linsenarray läßt sich mit folgenden Parametern herzustellen:
- Brennweite:: 5 mm
- Brechungsindex: 1,5
- Linsenmaterial:: PMMA
- Linsengröße:: 150 µm
- Linsenbegrenzung:: quadratisch
- Anzahl der Linsen:: 660 * 660

Ein 5"-Maskenblanc (Glassubstrat, beschichtet mit ca. 80 nm Chrom) wird mit einem Elektronenresist (PMMA-Copolymer) beschichtet. Bei der anschließenden Elektronenstrahlbelichtung werden zwei Datensätze benötigt. Mit einem ersten Datensatz wird das Schreiben einer Dosisverteilung für 660 * 660 Zylinderlinsenprofile mit Brechkraft in x-Richtung realisiert (Fig. 7 a). Fig. 7d zeigt für ein Linsenprofil die ideale Dosisverteilung in x-Richtung; in y-Richtung (150 µm) ist die Dosis konstant. Diese Dosisverteilung wird durch 90 Dosisstufen, die jeweils einer zu belichtenden rechteckigen Strukturfläche (Rechteck) entsprechen, approximiert. Ein zweiter Datensatz schreibt das gleiche Array um 90° gedreht in die Resistschicht (Fig. 7b). Nach einer zeitlich begrenzten Entwicklung ist das Oberflächenprofil voll ausgebildet (Fig. 7c).

Die minimale Anzahl rechteckiger Flächen (Rechtecke), die für eine Hälfte eines Zylinderlinsenprofils benötigt wird, ist gleich der Anzahl der Dosisschritte (hier 90). Für die insgesamt vier Hälften der beiden gekreuzten Zylinderlinsen ergeben sich also 360 Rechtecke. Aufgrund der Anordnung der Linsen im Array sind durch Zusammenlegen angrenzender Rechtecke weitere Optimierungen möglich. Die Bearbeitung der gleichen Linsenstruktur nach dem herkömmlichen radialen Zerlegungsverfahren entsprechend Fig. 2 führt auf mindestens 18.980 Rechtecke. Im Falle einer Abarbeitung der Daten auf einer Elektronenstrahlbelichtungsanlage ergibt der Vergleich zwischen beiden Varianten ein Zeitgewinn um einen Faktor ca. 30 bei der Anwendung des erfindunsgemäßen Verfahrens.

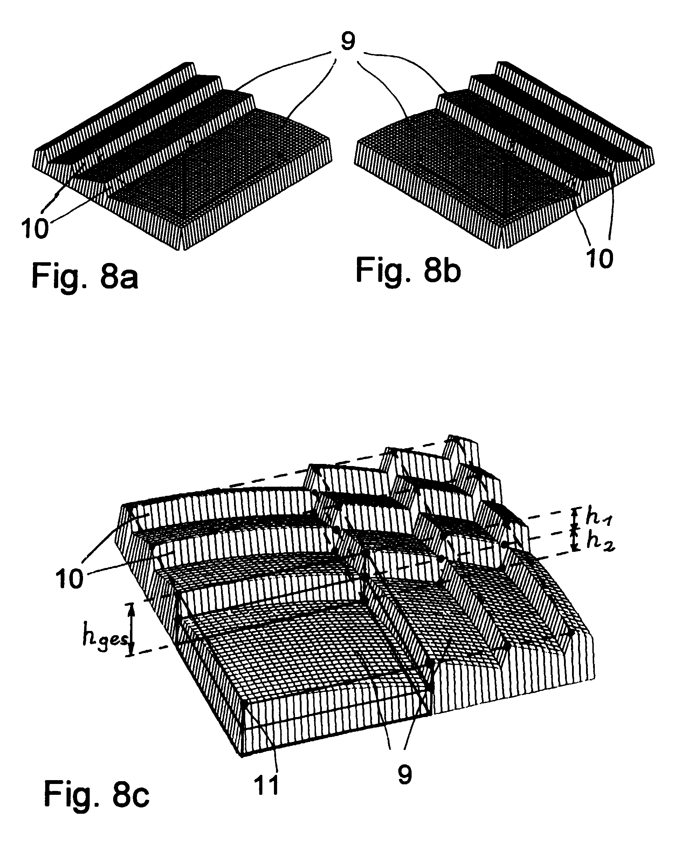

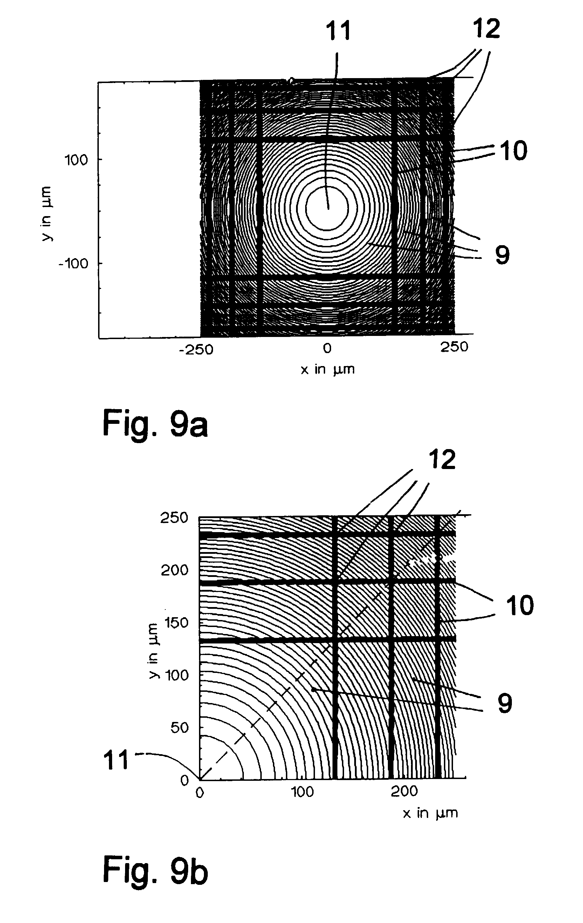

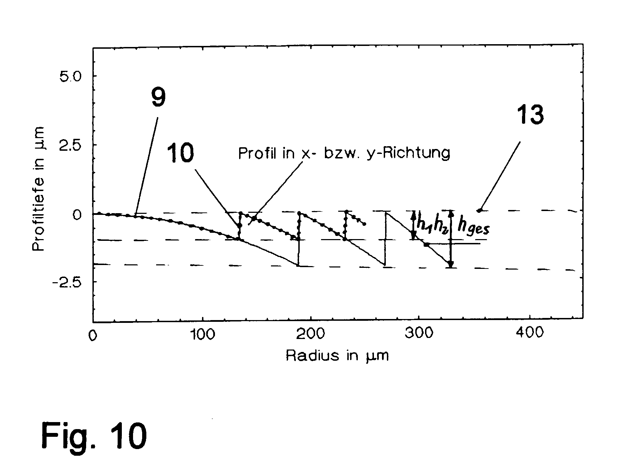

Die Figuren 8 bis 10 verdeutlichen die Erzeugung einer Fresnellinse gemäß der Erfindung durch Überlagerung von Dosisverteilungen, die Fresnel-Zylinder-Lisen mit rechtwinklig zueinander gerichteten Zylinderachsen entsprechen.
Modifikationen sind selbstverständlich mit anderen Kombinationen von Dosisverteilungen entsprechend strukturierter Zylinderlinsen möglich, wobei die Zylinderachsen einen von 90° abweichenden, praktisch sinnvollen Winkel einschließen können.
Mit der Erfindung sind Linsenprofile mit radialsymmetrischer oder elliptischer optischer Wirkung erzeugbar.
Gemäß den Figuren 8 und 9 besteht die Fresnellinse aus Stufen in Form von benachbarten Stufenelementen 9, die in ein durch ihre rechtwinklig zueinander gerichteten Flanken 10 gebildetes, mit zunehmendem Abstand vom Zentrum 11 der Linse enger werdendes Gitternetz eingebettet sind.
Die Flanken 10 bilden an ihren Schnittpunkten 12 und an Punkten des Lotes vom Zentrum 11 auf die Flanken 10 gemeinsam mit dem Zentrum 11 Orte gleicher Höhen, von denen richtungsabhängige Höhenreduzierungen h₁, h₂ und h_{ges} in jedem Stufenelement ausgehen. Der Übersicht halber sind von den Stufenelementen 9, den Flanken 10 und den Schnittpunkten 12 nur ein Teil bezeichnet ist,
Innerhalb jeder Richtung senkrecht zu den Flanken 10 und zum Rand der Linse weisend liegen gleichgroße Höhenreduzierungen von Flanke zu Flanke vor, in einer Richtung h₁ und in einer dazu senkrechten h₂. Die Höhenreduzierungen h₁ und h₂ können gleich oder unterschiedlich groß zueinander sein.
In Richtung der entferntesten, zum Rand der Linse gelegenen Schnittpunkte 12 entsprechen die Höhenreduzierungen h_{ges} der Summe aus h₁ und h₂.
Das in Figur 10 dargestellte Höhenprofil des Fresnel-Zylinderlinsen-Ausschnittes entsprechend Figur 8 c und 9 b verdeutlicht diesen Sachverhalt nochmals.
Legt man den Fresnel-Zylinderlinsen-Ausschnitt in ein kartesisches Koordinatensystem so liegt in x-Richtung die Höhenreduzierung h₁ und in y-Richtung die Höhenreduzierung h₂ vor, wobei im vorliegenden Beispiel h₁ = h₂ ist. In Richtung der entferntesten, zum Rand der Linse gelegenen Schnittpunkte 12 sind die Höhenreduzierungen h_{ges}.
Die Höhenreduzierungen h₁ und h₂ besitzen ein Maß, mit dem ein Phasensprung vom ganzzahligen Vielfachen einer Wellenlänge realisiert wird.
Die Flanken 10 erheben sich vom tiefsten, einem Schnittpunkt 12 im wesentlichen entsprechenden Punkt nahezu senkrecht bis zur Resistoberfläche 13. Nach außen gerichtet schließen sich wiederum die Höhenreduzierungen h₁, h₂ und h_{ges} an.

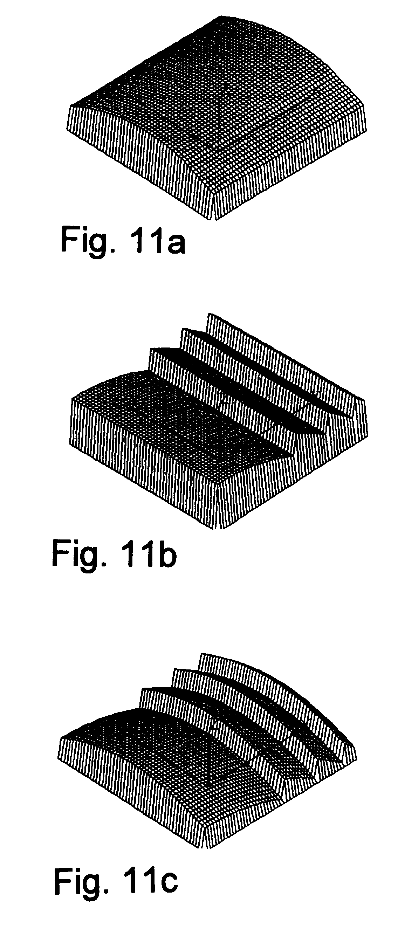

Die Figuren 11 a-c verdeutlichen die Erzeugung einer Fresnellinse mit entlang der x-Achse in z-Richtung gekrümmten fresnelschen Zonen durch Überlagerung der Dosis, die einer Zylinderlinse und einer Dosis, die einer Fresnel-Zylinderlinse enspricht.

Natürlich ist die Erfindung nicht allein auf die Anwendung von Elektronenstrahlen beschränkt. Die Bestrahlungen können auch mit Licht, Röntgenstrahlen oder Ionen erfolgen.

## Patentansprüche

1. Lithografisch hergestellte Stufenlinse fresnelscher Oberflächenstruktur mit radialsymmetrisch oder elliptisch optischer Wirkung durch Überlagerung von Strahlungsdosisverteilungen von Zylinderlinsen mit zueinander um einen Winkel versetzten Zylinderachsen, dadurch gekennzeichnet, daß
zur Erzeugung der Oberflächenstruktur mindestens eine Strahlungsdosisverteilung einer Fresnel-Zylinderlinse entspricht.

2. Lithografisch hergestellte Stufenlinse nach Anspruch 1, dadurch gekennzeichnet, daß die Oberflächenstruktur durch die Überlagerung der Strahlungsdosisverteilungen von zwei Fresnel-Zylinderlinsen mit rechtwinklig zueinander gerichteten Zylinderachsen erzeugt ist und Stufen in Form von benachbarten Stufenelementen aufweist, die in ein durch ihre rechtwinklig zueinander gerichteten Flanken gebildetes, mit zunehmendem Abstand vom Zentrum der Linse enger werdendes Gitternetz eingebettet sind,
wobei die Flanken an ihren Schnittpunkten und an Punkten des Lotes vom Zentrum auf die Flanken gemeinsam mit dem Zentrum Orte gleicher Höhen bilden,
und daß für jedes Stufenelement von den Orten gleicher Höhen ausgehende Höhenreduzierungen vorliegen,
die innerhalb jeder Richtung senkrecht zu den Flanken und zum Rand der Linse weisend von Flanke zu Flanke gleichgroß sind und
in Richtung der entferntesten, zum Rand der Linse gelegenen Schnittpunkte der Summe der von Flanke zu Flanke auftretenden Höhenreduzierungen eines Stufenelementes entsprechen.

3. Lithografisch hergestellte Stufenlinse nach Anspruch 2, dadurch gekennzeichnet, daß die Höhenreduzierungen innerhalb der Richtungen senkrecht zu den Flanken ein Maß besitzen, mit dem ein Phasensprung vom ganzzahligen Vielfachen einer Wellenlänge realisiert wird.

4. Verfahren zur Herstellung von Stufenlinsen vom fresnelschen Typ, bei dem eine Strukturierung einer Resistschicht durch Übereinanderbelichten zweier Strahlungsdosisverteilungen von Zylinderlinsen mit um einen Winkel versetzten Zylinderachsen und durch einen anschließenden Entwicklungsvorgang, bei dem ein Voranschreiten einer Entwicklungsfront in der Tiefe der Schicht gestoppt wird, erfolgt, dadurch gekennzeichent, daß
von den übereinanderbelichteten Strahlungsdosisverteilungen mindestens eine einer Fresnel-Zylinderlinse entspricht.

5. Verfahren nach Anspruch 4, dadurch gekennzeichnet, daß
die eine Strahlungsdosisverteilung einem fresnelschen Linsenprofil und die andere einem klassischen Linsenprofil entspricht.

6. Verfahren nach Anspruch 4, dadurch gekennzeichnet, daß
beide Strahlungsdosisverteilungen einem fresnelschen Linsenprofil entsprechen.

7. Verfahren nach Anspruch 4, dadurch gekennzeichnet, daß
beide Strahlungsdosisverteilungen einem klassischen Linsenprofil entsprechen.

## Claims

1. Lithographically produced stepped lens with a Fresnel surface structure with radially symmetrical or elliptical optical effect by superimposition of radiation dose distributions from cylindrical lenses with cylinder axes offset to one another by an angle, characterised in that for the purpose of producing the surface structure at least one radiation dose distribution corresponds to a Fresnel cylindrical lens.

2. Lithographically produced stepped lens as claimed in Claim 1, characterised in that the surface structure is produced by the superimposition of the radiation dose distributions from two Fresnel cylindrical lens with cylinder axes directed at right angles to one another and has steps in the form of adjacent step elements which are embedded in a grid system which is formed by their flanks directed at right angles to one another and which becomes smaller with increasing distance from the centre of the lens, whereby the flanks form together with the centre locations of the same heights at their points of intersection and at points of the perpendicular from the centre to the flanks, and that for each step element, starting from the locations of the same heights, height reductions are present which are of the same size in each direction perpendicular to the flanks and to the edge of the lens pointing from flank to flank and in the direction of the most distant points of intersection positioned towards the edge of the lens correspond to the sum of the height reductions occurring from flank to flank of a step element.

3. Lithographically produced stepped lens as claimed in Claim 2, characterised in that the height reductions have a size in the directions perpendicular to the flanks with which a phase shift of whole number multiples of a wavelength is produced.

4. Method of producing stepped lenses of Fresnel type in which structuring of a resist layer is effected by superimposing two radiation dose distributions from cylindrical lenses with cylinder axes offset by an angle and by a subsequent development process in which advance of a development front in the depth of the layer is stopped, characterised in that at least one of the superimposed radiation dose distributions corresponds to a Fresnel cylindrical lens.

5. Method as claimed in Claim 4, characterised in that one radiation dose distribution corresponds to a Fresnel lens profile and the other corresponds to a classical lens profile.

6. Method as claimed in Claim 4, characterised in that both radiation dose distributions correspond to a Fresnel lens profile.

7. Method as claimed in Claim 4, characterised in that both radiation dose distributions correspond to a classical lens profile.

## Revendications

1. Lentille en gradins réalisée manière lithographique, à structure de surface de Fresnel, avec un effet optique répondant à une symétrie radiale ou elliptique, en opérant par superposition de distributions de la dose de rayonnement pour des lentilles cylindriques ayant des axes de cylindre décalés les uns des autres de la valeur d'un angle donné, caractérisée en ce qu'au moins une distribution de la dose de rayonnement correspond à une lentille cylindrique de Fresnel, en vue de produire la structure de surface.

2. Lentille en gradins fabriquée de façon lithographique selon la revendication 1, caractérisée en ce que la structure de surface est produite par la superposition des distributions du dosage de rayonnement de deux lentilles cylindriques de Fresnel ayant des axes de cylindre orientés à angle droit l'un par rapport à l'autre et présente des gradins se présentant sous la forme d'éléments en gradin voisins, qui sont intégrés dans un réseau à grille, devenant de plus en plus étroit lorsque la distance vis-à-vis du centre de la lentille va en augmentant et constitués par leurs flans orientés à angle droit les uns par rapport aux autres,
les flans constituant des lieux de même hauteur, sur leur point d'intersection et sur les points de la verticale vis-a-vis du centre sur les flans, conjointement avec le centre,
et en ce que pour chaque élément en gradin existent des réductions de hauteur partant des lieux ayant les mêmes hauteurs,
ces réductions de hauteur étant de même valeur dans chaque direction orientée perpendiculairement par rapport aux flans et en direction du bord de la lentille en étant tournées d'un flan à un autre, et
dans la direction des points d'intersection les plus éloignés, placées sur le bord de la lentille, elles correspondent à la somme des réductions de hauteur, se manifestant d'un flan à un autre flan, d'un élément en gradin.

3. Lentille en gradins fabriquée par lithographie selon la revendication 2, caractérisée en ce que les réductions de hauteur ont, dans les directions perpendiculaires aux flans, une valeur à l'aide de laquelle est réalisé un saut de phase d'un multiple entier d'une longueur d'onde.

4. Procédé de fabrication de lentille en gradins du type Fresnel, dans lequel une structuration d'une couche résist s'effectue par illumination l'une au-dessus de l'autre de deux distributions de dose d'irradiation de lentilles cylindriques avec des axes de cylindre décalés d'un angle donné et au moyen d'un processus de développement subséquent, dans lequel la progression d'un front de développement est stoppée à la profondeur de la couche, caractérisé en ce que parmi les distributions de dose d'irradiation faisant l'objet d'une illumination l'une au-dessus de l'autre au moins l'une correspond à une lentille cylindrique de Fresnel.

5. Procédé selon la revendication 4, caractérisé en ce que une distribution de dose d'irradiation correspond à un profil de lentille de Fresnel et l'autre à un profil de lentille classique.

6. Procédé selon la revendication 4, caractérisé en ce que les deux distributions de dose d'irradiation correspondent à un profil de lentille de Fresnel.

7. Procédé selon la revendication 4, caractérisé en ce que les deux distributions de dose d'irradiation correspondent à un profil de lentille classique.
